# EUROPÄISCHE PATENTSCHRIFT

(11) **EP 2 257 975 B1**
(45) Veröffentlichungstag und Bekanntmachung des Hinweises auf die Patenterteilung: **17.10.2012**
(21) Anmeldenummer: 09726423.8
(22) Anmeldetag: 20.03.2009
(51) Int. Cl.: H01L 21/60

(54) **VERFAHREN UND VORRICHTUNG ZUR APPLIKATION EINES CHIPMODULS**
METHOD AND DEVICE FOR APPLICATION OF A CHIP MODULE
PROCÉDÉ ET DISPOSITIF D'APPLICATION D'UN MODULE DE PUCE

(30) Priorität: 28.03.2008 DE 102008016830
(43) Veröffentlichungstag der Anmeldung: 08.12.2010
(73) Patentinhaber: Smartrac IP B.V., 1077 XX Amsterdam (NL)
(72) Erfinder: RIETZLER, Manfred, 87616 Marktoberdorf (DE); FREEMAN, Raymond, Mesa Arizona 85213 (US)
(74) Vertreter: Böck, Bernhard
(86) Internationale Anmeldenummer: PCT/EP2009/002067
(87) Internationale Veröffentlichungsnummer: WO 2009/118132

(56) Entgegenhaltungen:
- EP-A- 1 699 078
- WO-A-2004/088571
- DE-A1-102005 015 656
- US-B1- 6 200 824

## Beschreibung

Die vorliegende Erfindung betrifft ein Verfahren zur Applikation eines Chipmoduls auf ein Antennenmodul, wobei auf einer Applikationsseite des Chipmoduls ausgebildete Antennenkontaktflächen mit Kontaktflächen einer auf einer Antennenseite eines Antennensubstrats angeordneten Antenne elektrisch leitfähig kontaktiert werden, wobei eine Mehrzahl von Chipmodulen in einer Reihenanordnung auf einem Folienträger angeordnet ist und die Reihenanordnung vermittels einer Zuführeinrichtung einer am Applikationsort angeordneten Vereinzelungseinrichtung zugeführt wird, nachfolgend das aus der Reihenanordnung vereinzelte Chipmodul vermittels einer Applikationseinrichtung auf dem Antennensubstrat platziert wird und eine Kontaktierung der Antennenkontaktflächen des Chipmoduls mit den Kontaktflächen der Antenne erfolgt.

Darüber hinaus betrifft die Erfindung eine Vorrichtung zur Durchführung des vorgenannten Verfahrens nach dem Oberbegriff des Anspruchs 15.

Bei der Herstellung so genannter Transpondermodule in Großserie werden Antennenmodule, die jeweils eine mit Anschlusskontakten versehene Antenne auf einem Antennensubstrat aufweisen, in einer Matrixanordnung an einer Bestückungsstation vorbeigefördert, in der die einzelnen Antennen mit Chipmodulen kontaktiert werden. Insbesondere wegen der infolge der Matrixanordnung mittlerweile üblichen großen Bahnbreiten der Antennenmodulbahnen müssen zur Bestückung der Antennen mit den Chipmodulen teilweise erhebliche Handhabungsstrecken zurückgelegt werden, über die die Chipmodule bis zur Kontaktierung auf den Antennensubstraten vereinzelt geführt werden müssen. Regelmäßig erfolgt dabei die Zuführung der Chipmodule quer zur Transportrichtung der Antennensubstratbahn. Neben dem mit der Zuförderung der Chipmodule verbundenen zeitlichen Aufwand wird es als nachteilig empfunden, dass die Zuförderung der vereinzelten Chips die Installation entsprechend aufwendig ausgebildeter Transporteinrichtungen notwendig macht.

Aus der WO 2004/088571, A ist ein Verfahren zur Applikation eines Chipmoduls auf ein Antennenmodul und eine hier zu verwendende Vorrichtung bekannt, bei dem bzw. bei der die auf einem Folienträger angeordneten Chipmodule in einem Bereich, in dem eine Vereinzelungseinrichtung und eine Applikationseinrichtung, parallel zu einem weiteren Folienträger angeordnet sind, auf dem sich die Antennenmodule befinden. Zur Parallelführung des mit den Chipmodulen versehenen Folienträgers ist eine entsprechend aufwendige Transporteinrichtung erforderlich.

Die DE 10 2005 01 5656 A1 eine Transporteinrichtung für einen mit Chipmodulen bestückten Folienträger, die dazu dient, diesen Folienträger im Bereich einer Bestückungs- und Verbindungsvorrichtung benachbart und längs eines weiteren Folienträgers zu führen, der mit Antennenmodulen versehen ist, die jeweils mit einem Chipmodul zu bestücken sind.

Die EP-A-1 699 078 zeigt ein Verfahren, bei dem die Chipmodule, die zur Bestückung von auf einem Folienträger angeordneten Antennenmodulen bestimmt sind, nicht auf einem Folienträger zu einer Bestückungs - und Verbindungsstation überführt werden, sondern bereits in vereinzelter Form über einen als Vibrationsförderer ausgebildeten Linearförderer zur Bestückungs- und Verbindungsstation geführt werden.

Der vorliegenden Erfindung liegt daher die Aufgabe zu Grunde, die Zuförderung von Chipmodulen zur nachfolgenden Kontaktierung mit den Antennenmodulen effektiver, also insbesondere schneller und mit einem vergleichsweise geringen apparativen Aufwand, zu ermöglichen.

Diese Aufgabe wird durch ein Verfahren mit den Merkmalen des Anspruchs 1 bzw. einer Vorrichtung mit den Merkmalen des Anspruchs 16 gelöst.

Bei dem erfindungsgemäßen Verfahren erfolgt die Zuführung einer Mehrzahl von in einer Reihenanordnung auf einem Folienträger angeordneten Chipmodulen zu einer Vereinzelungseinrichtung, die am Applikationsort angeordnet ist. Hierdurch entfällt der logistische und apparative Aufwand, der mit der Handhabung und dem Transport bereits zuvor vereinzelter Chipmodule verbunden ist, die in vereinzelter Form zum Applikationsort hin transportiert werden müssen. Stattdessen wird erfindungsgemäß die Reihenanordnung selbst, also eine einfache Vorbewegung der Reihenanordnung, genutzt, um die im Reihenverbund angeordneten Chipmodule zum Applikationsort zu transportieren und erst dort, wo die Applikation stattfindet, aus dem Reihenverbund zu verein-zeln, vermittels der Applikationseinrichtung auf dem Antennensubstrat zu platzieren und mit der Antenne zu kontaktieren.

Erfindungsgemäß erfolgt demnach die Vereinzelung des Chipmoduls erst im Bereich der Applikationseinrichtung, so dass vorteilhaft die Folienträgeranordnung selbst zum Transport bis zur Applikationseinrichtung genutzt werden kann.

Erfindungsgemäß wird zur Vereinzelung die Reihenanordnung der Chipmodule so weit aus einem Zuführkanal herausgeführt, bis ein hinteres Längsende des aus dem Zuführkanal vorstehenden Chipmoduls an eine erste, das Ende des Zuführspalts definierende, feststehende Schneidkante der Vereinzelungseinrichtung gelangt. Nachfolgend wird zum Abtrennen bzw. Vereinzeln des vorderen Chipmoduls aus der Reihenanordnung ein Schneidarm mit einer zweiten Schneidkante an der feststehenden Schneidkante vorbeigeschwenkt. Das Verfahren ermöglicht somit den Einsatz einer auf engstem Raum unterbringbaren Vorrichtung, die die Schneidbewegung gleichzeitig zur Übergabe des abgeschnittenen bzw. vereinzelten Chipmoduls an die Applikationseinrichtung nutzt.

Die Effektivität des erfindungsgemäßen Verfahrens kann noch erhöht werden, wenn der Folienträger eine Mehrzahl von parallel zueinander, in Längsrichtung des Folienträgers verlaufende Reihenanordnungen aufweist, die räumlich entfernt zum Applikationsort vereinzelt werden, um am Applikationsort als einzelne Reihenanordnungen der Vereinzelungseinrichtung zugeführt zu werden.

Dabei kann die Vereinzelung der Reihenanordnungen aus dem Folienträger während der Zuführung der Reihenanordnungen zur Vereinzelungseinrichtung oder unabhängig davon erfolgen, wobei letzteres betreffend die aus dem Folienträger vereinzelten Reihenanordnungen jeweils aufgerollt als Vorratsrolle auf einer Vorratseinrichtung angeordnet und erst nachfolgend ausgehend von der Vorratseinrichtung jeweils der Vereinzelungseinrichtung zugeführt werden können.

Besonders vorteilhaft hinsichtlich einer mechanisch belastbaren und abgedichteten Verbindung des Chipmoduls zum Antennenmodul ist es, wenn nachfolgend der Plazierung und vorausgehend der Kontaktierung in einem einen Chip und die Antennenkontaktflächen umgebenden Kontaktbereich eine Klebeverbindung zwischen dem Chipmodul und dem Antennensubstrat erfolgt.

Abweichend hiervon ist es auch möglich, wenn die Klebeverbindung nachfolgend der Kontaktierung erfolgt.

Um eine bereits während der Zuführung der Chipmodule in Reihenanordnung definierte räumliche Ausrichtung der Chipmodule definiert beizubehalten und Positionsänderungen des Chipmoduls aufgrund der Schneidbewegung weitestgehend ausschließen zu können, ist es vorteilhaft, wenn das vorstehende Chipmodul während des Abtrennens von der Reihenanordnung und der Übergabe an die Applikationseinrichtung auf einer Anlagefläche des Schneidarms gehalten wird. Gleichzeitig ist hiermit sichergestellt, dass sich das vereinzelte Chipmodul während der Übergabe an die Applikationseinrichtung in einer definierten Position befindet.

Eine besonders effektive und apparativ wenig aufwendige Möglichkeit zur Realisierung einer Haltefunktion besteht, wenn das Chipmodul durch eine Unterdruckbeaufschlagung gegen die Anlagefläche gehalten wird.

Um auch nach Übergabe an die Applikationseinrichtung eine definierte reproduzierbare Positionierung des Chipmoduls sicherzustellen, ist es vorteilhaft, wenn zur Übergabe des Chipmoduls an die Applikationseinrichtung der Schneidarm mit seiner Anlagefläche gegen eine Anlagefläche der Applikationseinrichtung geschwenkt wird, derart, dass die Unterdruckbeaufschlagung am Schneidarm bis zur Anlage gegen die Anlagefläche der Applikationseinrichtung aufrechterhalten wird und anschließend eine Unterdruckbeaufschlagung des Chipmoduls über die Anlagefläche der Applikationseinrichtung erfolgt.

Eine nach Übergabe des Chipmoduls an die Applikationseinrichtung möglichst direkt erfolgende Applikation wird möglich, wenn zur Platzierung mit nachfolgender Kontaktierung die Applikationseinrichtung mit dem auf der Anlagefläche gehaltenen Chipmodul gegen das Antennensubstrat bewegt und während der Anlage gegen das Antennensubstrat mit Ultraschallschwingungen beaufschlagt wird.

Eine vorteilhafte Anpassung des Verfahrens an die jeweilige Breite der Antennenmodulbahn bzw. die Anzahl der über die Breite der Antennenmodulbahn angeordneten Antennenmodule wird möglich, wenn zur Zuführung, Vereinzelung und Applikation der Chipmodule für eine Vielzahl von in einer Matrixanordnung angeordneten Antennensubstraten eine der Anzahl der in Vorschubrichtung vorbewegten Reihen der Matrixanordnung entsprechende Anzahl von Reihenanordnungen der Chipmodule der Matrixanordnung zugeordnet wird, derart, dass die Reihenanordnungen in die gleiche Richtung wie die zugeordneten Reihen der Matrixanordnung vorbewegt werden.

Besonders einfach und Platz sparend wird die Durchführung des Verfahrens bei in einer Matrixanordnung angeordneten Antennenmodulen möglich, wenn die jeder Reihe der Matrixanordnung zugeordneten Zuführungs-, Vereinzelungs- und Applikationseinrichtungen in einer stationären Portalanordnung aufgenommen sind und die in Matrixanordnung angeordneten Antennenmodule unter der Portalanordnung getaktet hindurchgeführt werden.

Die erfindungsgemäße Vorrichtung weist zur Lösung der Aufgabe die Merkmale des Anspruchs 5 auf.

Die erfindungsgemäße Vorrichtung weist eine Zuführeinrichtung zur Zuführung einer Mehrzahl von Chipmodulen in einer Reihenanordnung auf einem Folienträger auf, eine Vereinzelungseinrichtung zur Vereinzelung der Chipmodule aus der Reihenanordnung und Übergabe des vereinzelten Chipmoduls an eine Applikationseinrichtung, wobei die Applikationseinrichtung zur Platzierung des Chipmoduls auf einem Antennensubstrat des Antennenmoduls und Kontaktierung der Antennenkontaktflächen des Chipmoduls mit den Kontaktflächen der Antenne dient.

Erfindungsgemäß weist die Vorrichtung eine Vereinzelungseinrichtung mit einem Zuführkanal auf, der mit einer in Zuführrichtung am vorderen Ende ausgebildeten Schneidkante und einem gegenüber dem Zuführkanal verschwenkbaren Schneidarm mit einer zweiten Schneidkante versehen ist, die an der ersten Schneidkante vorbei bewegbar ist.

Besonders vorteilhaft ist es, wenn der Schneidarm mit einer Anlagefläche zur Aufnahme des Chipmoduls versehen ist, die mit einer Halteeinrichtung zur Fixierung des Chipmoduls an der Anlagefläche versehen ist.

Vorzugsweise ist die Halteeinrichtung als eine in der Anlagefläche angeordnete Unterdruckeinrichtung ausgebildet.

Eine besonders Raum sparende, funktionsintegrierte Ausbildung der Vorrichtung wird möglich, wenn der Schneidarm mit seiner Anlagefläche gegen eine Anlagefläche der Applikationseinrichtung verschwenkbar ist und die Anlagefläche der Applikationseinrichtung mit einer Unterdruckeinrichtung zur Übernahme des Chipmoduls von der Anlagefläche des Schneidarnis versehen ist.

Zur unmittelbaren Durchführung der Applikation nach Übernahme des Chipmoduls von der Vereinzelungseinrichtung ist die Applikationseinrichtung mit einer Vorschubeinrichtung zur Bewegung des auf der Anlagefläche angeordneten Chipmoduls gegen das Antennensubstrat versehen und weist eine Ultraschalleinrichtung zur Beaufschlagung des an der Anlagefläche angeordneten Chipmoduls mit Ultraschallschwingungen auf.

Eine besonders kompakte Ausführung der Vorrichtung wird möglich, wenn die Zuführeinrichtung, die Vereinzelungseinrichtung und die Applikationseinrichtung ein auf einem gemeinsamen Tragrahmen angeordnetes Applikationsmodul bilden.

Ein quasi autarker, von außerhalb der Antennensubstratbahn angeordneten Vorratseinrichtungen im Wesentlichen unabhängiger Betrieb der Vorrichtung wird möglich, wenn das Applikationsmodul mit einer Vorratseinrichtung zur Anordnung eines Endlos-Folienträgers in Rollenform versehen ist.

Eine besonders einfache und schnelle Anpassung der Vorrichtung an wechselnde Bahnbreiten der Antennenmodulbahn bzw. wechselnde Anzahlen von in der Antennemodulbahn ausgebildeten Reihen von Antennenmodulen wird möglich, wenn die Applikationsmodule zur Ausbildung einer Applikationseinheit in beliebiger Anzahl miteinander kombinierbar sind.

Eine bevorzugte Variante des erfindungsgemäßen Verfahrens sowie eine bevorzugte, bei der Durchführung der Variante zum Einsatz kommende Vorrichtung werden anhand der nachfolgenden Zeichnung näher erläutert.

Es zeigen:
- **Fig. 1**: einen Folienträger mit einer Mehrzahl von darauf ausgebildeten Reihenanordnungen von Chipmodulen;
- **Fig. 2**: ein einzelnes Chipmodul in Draufsicht;
- **Fig. 3**: das Chipmodul in Seitenansicht;
- **Fig. 4**: eine Verfahrensvariante mit während der Zuführung des Folienträgers vereinzelten Reihenanordnungen;
- **Fig. 5**: eine Verfahrensvariante mit unabhängig von der Zuführung des Folienträgers vereinzelten Reihenanordnungen;
- **Fig. 6**: ein auf einem Antennenmodul kontaktiertes Chipmodul in Draufsicht;
- **Fig. 7**: eine Matrixanordnung von Antennenmodulen in Draufsicht;
- **Fig. 8**: eine Applikationsvorrichtung zur Applikation eines Chipmoduls auf einem Antennenmodul;
- **Fig. 9**: eine Versiegelungsvorrichtung zur mechanischen Versiegelung des auf das Antennenmodul aufgebrachten Chipmoduls;
- **Fig. 10A bis Fig. 10C**: die Arbeitsweise der Applikationsvorrichtung mit Darstellung der Zuführeinrichtung, der Vereinzelungseinrichtung und der Applikationseinrichtung;
- **Fig. 11**: die Applikationseinrichtung während der elektrischen Kontaktierung des Chipmoduls mit dem Antennenmodul;
- **Fig. 12**: die Versiegelungseinrichtung während der Versiegelung des Chipmoduls mit dem Antennenmodul;
- **Fig. 13**: eine Draufsicht auf das elektrisch mit dem Antennenmodul kontaktierte und mechanisch mit dem Antennenmodul versiegelte Chipmodul;
- **Fig. 14**: eine schematische Darstellung einer Anlage zur automatischen Applikation von Chipmodulen auf in einer Matrixanordnung angeordneten Antennenmodulen.

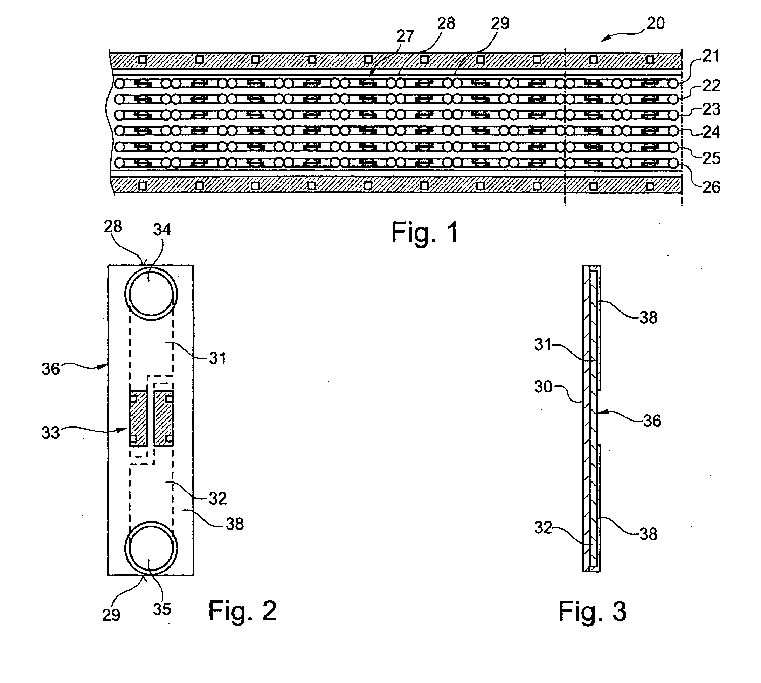

**Fig. 1** zeigt einen Folienträger 20 mit jeweils in einer Reihenanordnung 21, 22, 23, 24, 25 und 26 in Längsausrichtung hintereinander liegend angeordneten Chipmodulen 27. In den Reihenanordnungen 21 bis 26 sind die Chipmodule 27 jeweils so angeordnet, dass Längsenden 28, 29 benachbarter Chipmodule 27 unmittelbar aneinander angrenzen.

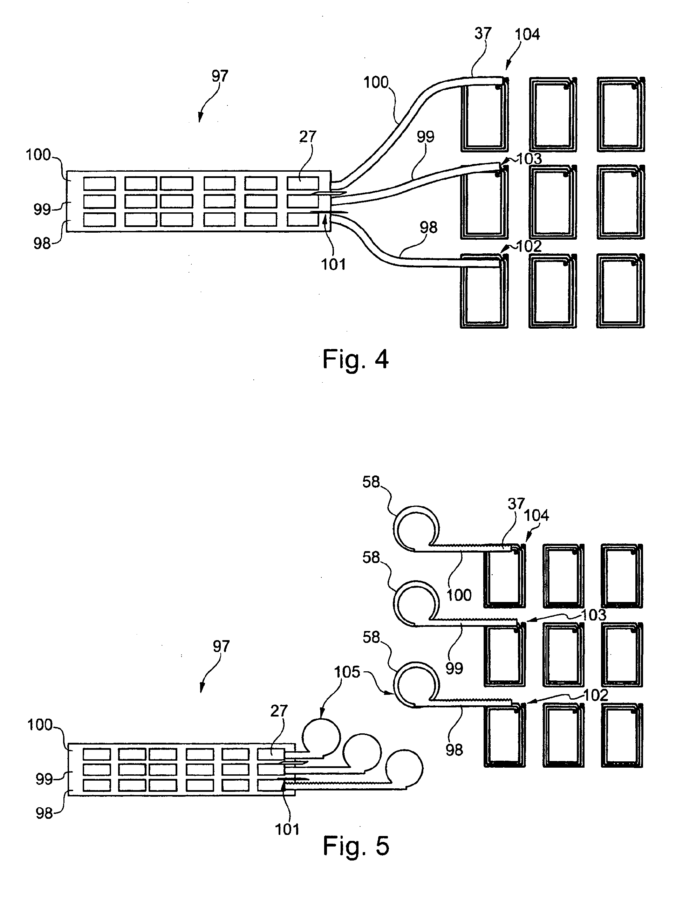

Wie die **Fig. 2 und 3** zeigen, umfasst jedes einzelne Chipmodul 27 ein Trägersubstrat 30, das aus dem Material des Folienträgers 20 gebildet ist und auf dem zwei Anschlussleiter 31, 32 ausgebildet sind, die in einem mittleren Bereich eine Kontaktflächenanordnung 33 zur Kontaktierung eines Chips und jeweils im Bereich der Längsenden 28, 29 des Chipmoduls 27 eine Antennenkontaktfläche 34 bzw. 35 aufweisen, die zur Ausbildung einer elektrischen Kontaktierung mit einem etwa in **Fig. 4** dargestellten Antennenmodul 37 dienen. Bis auf die Kontaktflächenanordnung 33 und die Antennenkontaktflächen 34, 35 ist bei dem in **Fig. 2** dargestellten Ausführungsbeispiel eine Applikationsfläche 36, über die das Chipmodul 27 mit dem in **Fig. 3** dargstellten Antennenmodul 37 verbunden wird, mit einer Auftragsschicht aus einem Klebermaterial 38 versehen.

**Fig. 4** zeigt in einer schematischen Darstellung eine Variante des Verfahrens, bei der aus einem Folienträger 97 mit einer Mehrzahl von parallel zueinander angeordneten und sich in Längsrichtung des Folienträgers erstreckenden Reihenanordnungen 98 bis 100 von Chipmodulen 27 räumlich entfernt von den in einer Matrixanordnung 42 bzw. einem Matrixverbund angeordneten Antennenmodulen 37 die Reihenanordnungen 98, 99, 100 vermittels einer hier als Schneideinrichtung 101 ausgebildeten Vereinzelungseinrichtung vereinzelt werden. Während der Vereinzelung werden die Reihenanordnungen 98, 99, 100 zu den jeweiligen Applikationsorten 102, 103, 104, wo die Chipmodule 27 mit den Antennenmodulen 37 kontaktiert werden, weitergefördert. Damit erfolgt die Vereinzelung der Reihenanordnungen 98, 99, 100 und deren Zuführung zu Applikationsorten 102, 103, 104 "in line".

**Fig. 5** zeigt in einer schematischen Darstellung eine Variante des Verfahrens, bei der die Reihenanordnungen 98 bis 100 unabhängig von der Zuführung und nachfolgenden Kontaktierung der Chipmodule zunächst vermittels der Schneideinrichtung 101 vereinzelt und anschließend jeweils zur Ausbildung einer Vorratsrolle 105 aufgerollt werden. Die Vorratsrollen 105 können dann auf Vorratseinrichtungen 58 in relativer Nähe zu den Applikationsorten 102, 103, 104 angeordnet werden. Ausgehend von den Vorratseinrichtungen 58 erfolgt dann eine Zuführung der Reihenanordnungen 98, 99, 100 zu den jeweiligen Applikationsorten 102, 103, 104, wo die Chipmodule 27 aus den Reihenanordnungen 98, 99, 100 vereinzelt und mit den Antennenmodulen 37 kontaktiert werden.

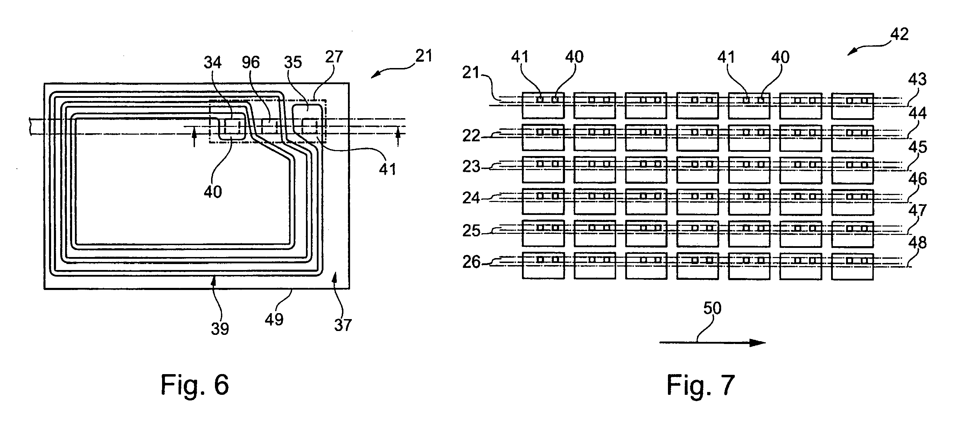

**Fig. 6** zeigt, wie bereits vorstehend erwähnt, ein Chipmodul 27, das auf dem Antennenmodul 37 appliziert ist, und zwar derart, dass ein auf dem Trägersubstrat 30 angeordneter bzw. mit der Kontaktflächenanordnung 33 kontaktierter Chip 96 über die in **Fig. 6** strichpunktiert angeordneten Antennenkontaktflächen 34, 35 mit Kontaktflächen 40, 41 einer Antenne 39 elektrisch leitend kontaktiert ist, die auf einem Antennensubstrat 49 des Antennenmoduls 37 ausgebildet sind.

Wie **Fig. 6** ferner zu entnehmen ist, erfolgt zur Applikation des Chipmoduls 27 auf dem Antennenmodul 37 eine vorhergehende Ausrichtung der dem Chipmodul 37 zugeordneten Reihenanordnung 21 bis 26 der Chipmodule 27, wie dies der Gesamtdarstellung in **Fig. 7** zu entnehmen ist. Vor der Applikation der zur Verbindung mit den einzelnen Antennenmodulen 37 bestimmten Chipmodule 27 erfolgt eine Zuordnung der Reihenanordnungen 21 bis 26, die in ihrer Anzahl den in einer Matrixanordnung 42 der Antennenmodule 37 ausgebildeten Reihen 43 bis 48 der Antennenmodule 37 entsprechen. Dabei befinden sich die Reihenanordnungen 21 bis 26 der Chipmodule 27 jeweils in einer fluchtenden Anordnung mit den Kontaktflächen 40, 41 der auf den Antennenmodulen 37 ausgebildeten Antennen 39.

Wie auch aus der schematischen Darstellung gemäß **Fig. 7** zu entnehmen ist, besteht grundsätzlich die Möglichkeit, bei einer abweichend von der Darstellung in **Fig. 1** ausgebildeten Teilung der Reihenanordnungen 21 bis 26 die einzelnen Chipmodule 27 der Reihenanordnungen 21 bis 26 in einem Abstand voneinander anzuordnen, der dem Abstand der Kontaktflächen 40 oder 41 benachbarter Chipmodule voneinander entspricht, so dass die Kontaktierung einer Mehrzahl von Chipmodulen 27 einer Reihenanordnung 21 bis 26 mit den in einer Reihe 43 bis 48 angeordneten Antennenmodulen 37 gleichzeitig erfolgen könnte.

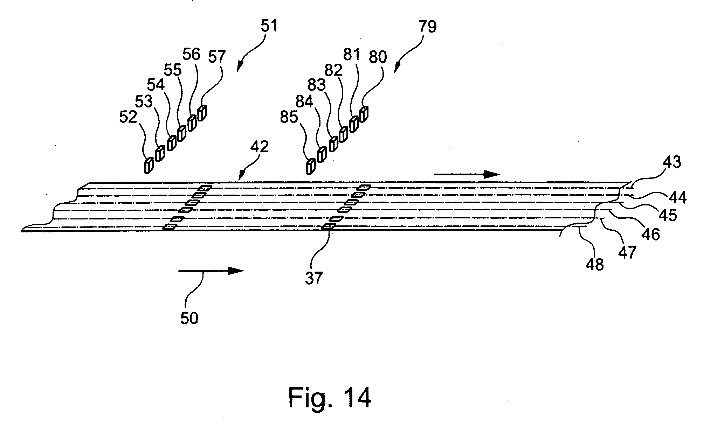

Hierzu würden die Matrixanordnung 42 der Antennenmodule 37 und die Reihenanordnungen 21 bis 26 der Chipmodule 27 synchron in Produktionsrichtung 50 vorbewegt werden. Alternativ ist es jedoch auch möglich, wie in **Fig. 14** dargestellt, feststehende, beispielsweise in einer gemeinsamen Portalanordnung 51 angeordnete Applikationsmodule 52 bis 57 vorzusehen, die den einzelnen Reihen 43 bis 48 der in Matrixanordnung 42 auf dem Antennenmodulträger 49 angeordneten Antennenmodule 37 zugeordnet sind. Dabei werden die einzelnen Reihen 43 bis 48 der Antennenmodule 37 unter der Portalanordnung 51 in Produktionsrichtung 50 hindurchbewegt.

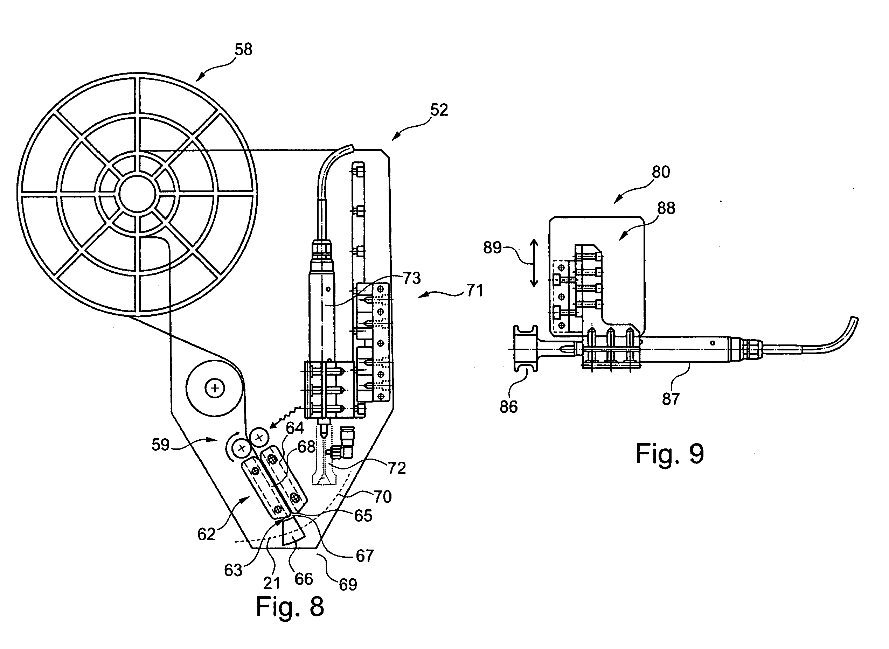

**Fig. 8** zeigt ein Applikationsmodul 52 in einer Einzeldarstellung mit den daran ausgebildeten Funktionseinrichtungen, die im Einzelnen eine Vorratseinrichtung 58, eine Zuführeinrichtung 59, eine Vereinzelungseinrichtung 60 und eine Applikationseinrichtung 61 umfassen. Die Vorratseinrichtung 58 dient zur Aufnahme einer Reihenanordnung 21 bis 26 der Chipmodule 27 im Rollenformat. Vermittels der Zuführeinrichtung 59, die im vorliegenden Fall aus einer Antriebsrolleneinheit besteht, wird die Reihenanordnung durch einen Zuführkanal 62 gefördert, der im Bereich seiner Austrittsöffnung 63 an einer Kanalwandung 64 mit einer Schneidkante 65 versehen ist. Verschwenkbar mit dem Zuführkanal 62 verbunden befindet sich ebenfalls im Bereich der Austrittsöffnung 63 ein Schneidarm 66, der ebenfalls mit einer Schneidkante 67 versehen ist, die bei einer Schwenkbewegung des Schneidarms 66 um eine am Zuführkanal 62 ausgebildete Schwenkachse 68 auf einem Schwenkbogen 70 an der Schneidkante 65 vorbeibewegt wird.

Benachbart zum Zuführkanal 62 und mit ihrer Zustellachse 69 den Schwenkbogen 70 durchschneidend befindet sich die Applikationseinrichtung 71, welche einen Ultraschallstempel 72 aufweist, der über einen Ultraschallkonverter 73 in Utraschallschwingungen versetzt wird.

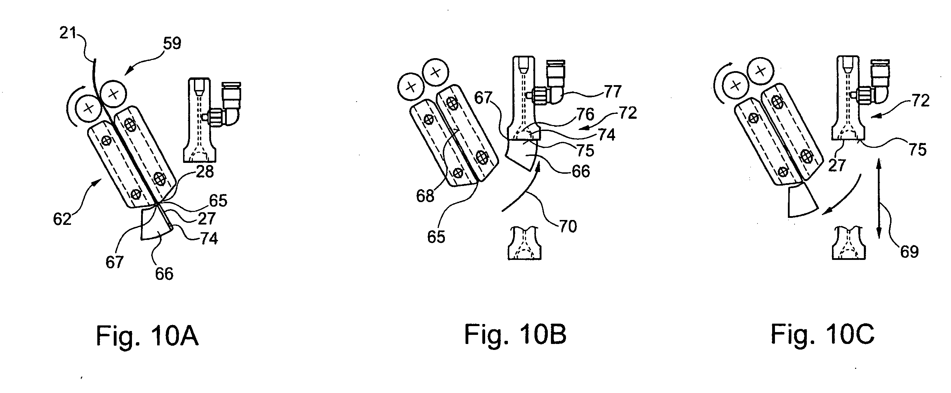

Nachfolgend wird unter Bezugnahme auf **Fig. 10A bis 10C** die Funktion des Applikationsmoduls 52 näher beschrieben.

Wie aus der Darstellung gemäß **Fig. 10A** zu entnehmen ist, wird vermittels der Zuführeinrichtung 59 die Reihenanordnung 21 so weit durch den Zuführkanal 62 vorbewegt, bis das zuvorderst in der Reihenanordnung 21 angeordnete Chipmodul 27 mit seinem hinteren Längsende 28 im Bereich der Schneidkante 65 angeordnet ist. In dieser Relativanordnung erstreckt sich das Chipmodul 27 über eine auf dem Schneidarm 66 ausgebildete Anlagefläche 74. Wenn das Chipmodul 27 die in **Fig. 10A** dargestellte Position auf der Anlagefläche 74 des Schneidarms 66 erreicht hat, wird die Anlagefläche 74 vermittels einer hier nicht näher dargestellten Unterdruckeinrichtung mit einem Unterdruck beaufschlagt, der das Chipmodul 27 auf der Anlagefläche 74 fixiert.

Ausgehend von der in **Fig. 10A** dargestellten Konfiguration erfolgt entsprechend der Darstellung in **Fig. 10B** ein Verschwenken des Schneidarms 66 um die Schwenkachse 68, derart, dass die Anlagefläche 74 mit dem darauf angeordneten Chipmodul 27 den Schwenkbogen 70 beschreibt, wobei die an der Anlagefläche 74 ausgebildete Schneidkante 67 an der feststehenden Schneidkante 65 vorbeibewegt wird, mit der Folge, dass das Chipmodul 27 im Bereich seines hinteren Längsendes 28 von der Reihenanordnung 21 abgetrennt wird.

Gleichzeitig mit der zum Abtrennen auf dem Schwenkbogen 70 ausgeführten Bewegung wird, wie **Fig. 10B** zu entnehmen ist, das auf der Anlagefläche 74 angeordnete Chipmodul 27 gegen eine am Ultraschallstempel 72 ausgebildete Anlagefläche 75 bewegt.

Wie aus der **Fig. 10B** zu entnehmen ist, ist die Anlagefläche 75 rückwärtig mit einer Unterdruckeinrichtung 76 versehen, die mit einem Unterdruckanschluss 77 zum Anschluss an eine hier nicht näher dargestellte Unterdruckquelle bestückt ist. Zur Übergabe des Chipmoduls 27 von der Anlagefläche 74 des Schneidarms 66 auf die Anlagefläche 75 des Ultraschallstempels 72 wird die Unterdruckbeaufschlagung der Anlagefläche 75 aktiviert und die Unterdruckbeaufschlagung der Anlagefläche 74 deaktiviert. Nach Deaktivierung der Unterdruckbeaufschlagung der Anlagefläche 74 erfolgt, wie in **Fig. 10C** dargestellt, eine Rückbewegung des Schneidarms 66 auf dem Schwenkbogen 70 bis zum Erreichen der in **Fig. 10A** dargestellten Ausgangsstellung des Schneidarms 66, in der vermittels einer erneuten Vorschubbewegung der Reihenanordnung 21 das in der Reihenanordnung nachfolgende Chipmodul 27 auf der Anlagefläche 74 positioniert werden kann.

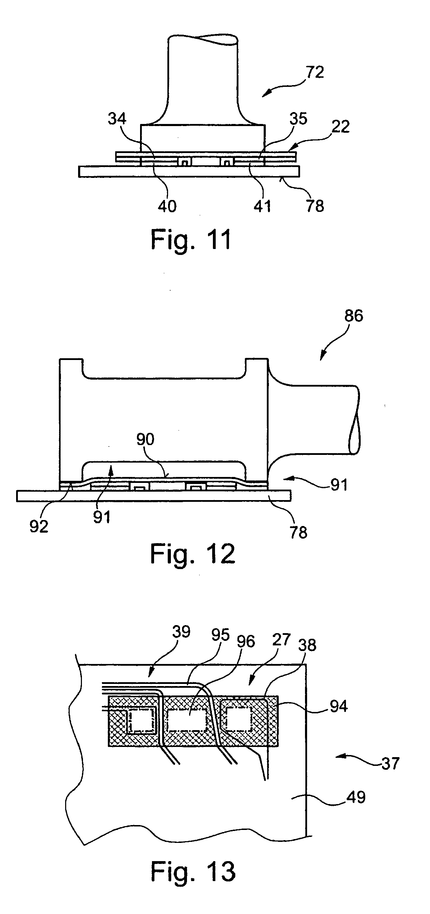

Gleichzeitig oder nachfolgend der Rückbewegung des Schneidarms 66 auf dem Schwenkbogen 70 erfolgt eine vertikale Zustellbewegung des Ultraschallstempels 72 längs der Zustellachse 69, derart, dass das über die Unterdruckbeaufschlagung an der Anlagefläche 75 fixierte Chipmodul 27 gegen das Antennensubstrat 78, wie in **Fig. 11** dargestellt, bewegt wird. Dabei werden die Antennenkontaktflächen 34, 35 des Chipmoduls 27 in Überdeckung mit den Kontaktflächen 40, 41 der Antenne 39 gebracht. Durch eine Beaufschlagung des Ultraschallstempels mit Ultraschallschwingungen wird schließlich ein elektrisch leitfähiger Schweißkontakt zwischen den Antennenkontaktflächen 34, 35 und den Kontaktflächen 40, 41 der Antenne 39 hergestellt. Besonders effektiv ist die Herstellung der Schweißverbindung in Ultraschalltechnik, wenn sowohl die Antennenkontaktflächen 34, 35 als auch die Kontaktflächen 40, 41 aus Aluminium bestehen.

Wie insbesondere aus der Darstellung gemäß **Fig. 14** zu entnehmen ist, ist neben der Portalanordnung 51 mit der Mehrzahl von daran ausgebildeten Applikationsmodulen 52 bis 57 eine weitere Portalanordnung 79 vorgesehen, die eine Mehrzahl von Versiegelungsmodulen 80 bis 85 aufweist. Die Versiegelungsmodule 80 bis 85 sind hinsichtlich ihrer Zuordnung zu den einzelnen Reihen 43 bis 48 der Antennenmodule 37 den Applikationsmodulen 52 bis 57 entsprechend angeordnet. Die Versiegelungsmodule 80 bis 85 befinden sich im Gegensatz zu den Applikationsmodulen 52 bis 57 in Produktionsrichtung 50 weiter vorn und dienen nachfolgend der vorausgegangenen elektrischen Kontaktierung der Antennenkontaktflächen 34, 35 des Chipmoduls 27 mit den Kontaktflächen 40, 41 der Antennen 39 der Antennenmodule 37 zur Ausbildung einer Versiegelung zwischen dem Chipmodul 27 bzw. dem Trägersubstrat 30 des Chipmoduls 27 und dem Antennensubstrat 49 des Antennenmoduls 37.

**Fig. 9** zeigt ein Versiegelungsmodul 80 mit einem Ultraschallstempel 86, der vermittels eines Ultraschallkonverters 87 mit Ultraschallschwingungen beaufschlagbar ist. Weiterhin ist der Ultraschallstempel 86 mit einer Zustelleinrichtung 88 versehen, die eine Zustellung des Ultraschallstempels 86 in Richtung einer Zustellachse 89 ermöglicht.

Wie aus einer Zusammenschau der **Fig. 9** **und** **12** deutlich wird, ist der Ultraschallstempel 86 mit einem Stempelprofil 91 versehen, das im Bereich einer Anlagefläche 92 gegen eine Rückseite des Trägersubstrats 30 einen umlaufenden Kontaktrahmen 93 ausbildet, dessen Abmessungen und Profilbreite so bemessen sind, dass sich ein in **Fig. 13** schraffiert dargestellter Kontaktbereich 94 mit dem Trägersubstrat 30 ergibt. In dem Kontaktbereich 94 ergibt sich infolge der Ultraschallbeaufschlagung des Trägersubstrats 30 eine feste, mechanisch belastbare Verbindung zwischen dem vorzugsweise als Kontaktkleber ausgebildeten, auf die Applikationsfläche 36 des Chipmoduls 27 aufgebrachten Klebermaterial 38 (**Fig. 2 und Fig. 3**) und dem Antennensubstrat 49 des Antennenmoduls 37. Aufgrund der isolierenden Wirkung des Klebermaterials 38 kann der eine hermetische Abdichtung und mechanisch belastbare Verbindung bewirkende Kleberkontakt sowohl zwischen dem Klebermaterial 38 und dem Substratmaterial des Antennensubstrats 49 als auch zwischen dem Klebermaterial 38 und vermittels des Chipmoduls 27 überbrückten Bereichen von Windungen 95 der Antenne 39 erfolgen.

## Patentansprüche

1. Verfahren zur Applikation eines Chipmoduls (27) auf ein Antennenmodul (37), wobei auf einer Applikationsseite (36) des Chipmoduls ausgebildete Antennenkontaktflächen (34, 35) mit Kontaktflächen (40, 41) einer auf einer Antennenseite eines Antennensubstrats (49) angeordneten Antenne (39) elektrisch leitfähig kontaktiert werden, wobei eine Mehrzahl von Chipmodulen in einer Reihenanordnung (21 bis 26; 98 bis 100) auf einem Folienträger (20, 97) angeordnet ist und die Reihenanordnung vermittels einer Zuführeinrichtung (59) einer am Applikationsort (102, 103, 104) angeordneten Vereinzelungseinrichtung (60) zugeführt wird, nachfolgend das aus der Reihenanordnung vereinzelte Chipmodul vermittels einer Applikationseinrichtung (61) auf dem Antennensubstrat platziert wird und eine Kontaktierung der Antennenkontaktflächen des Chipmoduls mit den Kontaktflächen der Antenne erfolgt
**dadurch gekennzeichnet,**
**dass** zur Vereinzelung die Reihenanordnung (21 bis 26) der Chipmodule (27) so weit aus einem Zuführkanal (62) herausgeführt wird, bis ein hinteres Längsende (28) des aus dem Zuführkanal hervorstehenden Chipmoduls an eine erste, das Ende des Zuführkanals definierende feststehende Schneidkante (65) der Vereinzelungseinrichtung (60) gelangt, und nachfolgend ein Schneidarm (66) mit einer zweiten Schneidkante (67) an der feststehenden Schneidkante zum Abtrennen des vorderen Chipmoduls von der Reihenanordnung und Übergabe an die Applikationseinrichtung (61) vorbeigeschwenkt wird.

2. Verfahren nach Anspruch 1,
**dadurch gekennzeichnet,**
**dass** der Folienträger (20, 97) eine Mehrzahl von parallel zueinander, in Längsrichtung des Folienträgers verlaufende Reihenanordnungen (21 bis 26; 98 bis 100) aufweist, die räumlich entfernt zum Applikationsort (102, 103, 104) vereinzelt werden, um am Applikationsort als einzelne Reihenanordnungen der Vereinzelungseinrichtung (60) zugeführt zu werden.

3. Verfahren nach Anspruch 2,
**dadurch gekennzeichnet,**
**dass** die Vereinzelung der Reihenanordnungen (98 bis 100) aus dem Folienträger (97) während der Zuführung der Reihenanordnung zur Vereinzelungseinrichtung (60) erfolgt.

4. Verfahren nach Anspruch 2,
dadurch **gekennzeinet**,
dass die Vereinzelung der Reihenanordnungen (98 bis 100) aus dem Folienträger (97) unabhängig von der Zuführung der Reihenanordnung zur Vereinzelungseinrichtung (60) erfolgt.

5. Verfahren nach Anspruch 4,
dadurch **gekennzeinet**,
dass die aus dem Folienträger (97) vereinzelten Reihenanordnungen (98 bis 100) jeweils aufgerollt und als Vorratsrolle (105) auf einer Vorratseinrichtung (58) angeordnet werden und nachfolgend ausgehend von der Vorratseinrichtung der Vereinzelungseinrichtung zugeführt werden.

6. Verfahren nach einem der vorangehenden Ansprüche,
**dadurch gekennzeichnet,**
**dass** nachfolgend der Platzierung und vorausgehend der Kontaktierung in einem einen Chip (96) und die Antennenkontaktflächen (34, 35) umgebenden Kontaktbereich (94) eine Klebeverbindung zwischen dem Chipmodul (27) und dem Antennensubstrat (49) erfolgt.

7. Verfahren nach einem der vorangehenden Ansprüche,
**dadurch gekennzeichnet,**
**dass** nachfolgend der Kontaktierung in einem einen Chip (96) und die Antennenkontaktflächen (34, 35) umgebenden Kontaktbereich (94) eine Klebeverbindung zwischen dem Chipmodul (27) und dem Antennensubstrat (49) erfolgt.

8. Verfahren nach Anspruch 1,
**dadurch gekennzeichnet,**
**dass** das vorstehende Chipmodul (27) während des Abtrennens von der Reihenanordnung (21 bis 26) und der Übergabe an die Applikationseinrichtung (61) auf einer Anlagefläche (74) des Schneidarms (66) gehalten wird.

9. Verfahren nach Anspruch 8,
**dadurch gekennzeichnet,**
**dass** das Chipmodul (27) durch Unterdruckbeaufschlagung gegen die Anlagefläche (74) gehalten wird.

10. Verfahren nach Anspruch 9,
**dadurch gekennzeichnet,**
**dass** zur Übergabe des Chipmoduls (27) an die Applikationseinrichtung (61) der Schneidarm (66) gegen eine Anlagefläche (75) der Applikationseinrichtung (61) geschwenkt wird, derart, dass die Unterdruckbeaufschlagung am Schneidarm bis zur Anlage gegen die Anlagefläche der Applikationseinrichtung aufrechterhalten wird und anschließend eine Unterdruckbeaufschlagung des Chipmoduls über die Anlagefläche (75) der Applikationseinrichtung erfolgt.

11. Verfahren nach einem oder mehreren der vorangehenden Ansprüche,
**dadurch gekennzeichnet,**
**dass** zur Platzierung mit nachfolgender Kontaktierung die Applikationseinrichtung (61) mit dem auf der Anlagefläche (75) gehaltenen Chipmodul (27) gegen das Antennensubstrat (49) bewegt und während der Anlage gegen das Antennensubstrat mit Ultraschallschwingungen beaufschlagt wird.

12. Verfahren nach einem oder mehreren der vorangehenden Ansprüche,
**dadurch gekennzeichnet,**
**dass** zur Herstellung des Kontaktbereichs (94) bei Durchführung der Klebeverbindung zwischen dem Chipmodul (27) und dem Antennensubstrat (49) das Chipmodul im Kontaktbereich mit Ultraschallschwingungen beaufschlagt wird.

13. Verfahren nach einem oder mehreren der vorangehenden Ansprüche,
**dadurch gekennzeichnet;**
**dass** zur Zuführung, Vereinzelung und Applikation der Chipmodule (27) für eine Vielzahl von in einer Matrixanordnung (42) angeordneten Antennenmodulen (37) eine der Anzahl der in Vorschubrichtung (50) vorbewegten Reihen (43 bis 48) der Matrixanordnung entsprechende Anzahl von Reihenanordnungen (21 bis 26) der Chipmodule (27) der Matrixanordnung zugeordnet wird, derart, dass die Reihenanordnungen in die gleiche Richtung mit den zugeordneten Reihen vorbewegt werden.

14. Verfahren nach Anspruch 13,
**dadurch gekennzeichnet,**
**dass** die jeder Reihe (43 bis 48) der Matrixanordnung (42) zugeordneten Zuführungs- (59), Vereinzelungs- (60) und Applikationseinrichtungen (61) in einer stationären Portalanordnung (51) aufgenommen sind, und die in Matrixanordnung angeordneten Antennenmodule (37) unter der Portalanordnung getaktet hindurchgeführt werden.

15. Vorrichtung zur Applikation eines Chipmoduls (27) auf ein Antennenmodul (37) mit einer Zuführeinrichtung (59) zur Zuführung einer Mehrzahl von Chipmodulen in einer Reihenanordnung (21 bi 26) auf einem Folienträger (20), einer Vereinzelungseinrichtung (60) zur Vereinzelung der Chipmodule aus der Reihenanordnung und Übergabe des vereinzelten Chipmoduls an eine Applikationseinrichtung (61), wobei die Applikationseinrichtung zur Platzierung des Chipmoduls auf einem Antennensubstrat (49) des Antennenmoduls (37) und Kontaktierung von Antennenkontaktflächen (34, 35) des Chipmoduls mit den Kontaktflächen (40, 41) der Antenne (39) dient,
**dadurch gekennzeichnet,**
**dass** die Vereinzelungseinrichtung (60) einen Zuführkanal (62) mit einer in Zuführrichtung am vorderen Ende ausgebildeten Schneidkante (65) und einem gegenüber dem Zuführkanal verschwenkbaren Schneidarm (66) mit einer zweiten Schneidkante (67) aufweist, die an der ersten Schneidkante vorbei bewegbar ist.

16. Vorrichtung nach Anspruch 15,
**dadurch gekennzeichnet,**
**dass** der Schneidarm (66) mit einer Anlagefläche (74) zur Aufnahme des Chipmoduls (27) versehen ist, die mit einer Halteeinrichtung zur Fixierung des Chipmoduls an der Anlagefläche versehen ist.

17. Vorrichtung nach Anspruch 16,
**dadurch gekennzeichnet,**
**dass** die Halteeinrichtung als eine in der Anlagefläche angeordnete Unterdruckeinrichtung ausgebildet ist.

18. Vorrichtung nach einem der Ansprüche 15 bis 17,
**dadurch gekennzeichnet,**
**dass** der Schneidarm (66) mit seiner Anlagefläche (74) gegen eine Anlagefläche (75) der Applikationseinrichtung(61) verschwenkbar ist, und die Anlagefläche der Applikationseinrichtung mit einer Unterdruckeinrichtung (76) zur Übernahme des Chipmoduls von der Anlagefläche des Schneidarms versehen ist.

19. Vorrichtung nach einem der Ansprüche 15 bis 18,
**dadurch gekennzeichnet,**
**dass** die Applikationseinrichtung (61) eine Vorschubeinrichtung zur Bewegung des auf der Anlagefläche (75) angeordneten Chipmoduls (27) gegen das Antennensubstrat (49) und eine Ultraschalleinrichtung zur Beaufschlagung des an der Anlagefläche angeordneten Chipmoduls mit Ultraschallschwingungen aufweist.

20. Vorrichtung nach einem der Ansprüche 15 bis 19,
**dadurch gekennzeichnet,**
**dass** die Zuführeinrichtung (59), die Vereinzelungseinrichtung (60) und die Applikationseinrichtung (61) ein auf einem gemeinsamen Tragrahmen angeordnetes Applikationsmodul (52 bis 57) bilden.

21. Vorrichtung nach Anspruch 20,
**dadurch gekennzeichnet,**
**dass** das Applikationsmodul (52 bis 57) mit einer Vorratseinrichtung (58) zur Anordnung eines Endlos-Folienträgers (20) in Rollenform versehen ist.

22. Vorrichtung nach Anspruch 20 oder 21,
**dadurch gekennzeichnet,**
**dass** die Applikationsmodule(52 bis 57) zur Ausbildung einer Applikationseinheit in beliebiger Anzahl miteinander kombinierbar sind.

## Claims

1. Method for application of a chip module (27) to an antenna module (37), wherein antenna contact surfaces (34, 35) formed on an application side (36) of the chip module are contacted with contact surfaces (40, 41) of an antenna (39) disposed on an antenna side of an antenna substrate (49) in an electrically conductive manner, wherein a plurality of chip modules are arranged in a row arrangement (21 to 26; 98 to 100) on a sheet carrier (20, 97) and the row arrangement is supplied to a separating device (60) arranged at the application location (102, 103, 104) by means of a supply device (59), the chip module separated from the row arrangement is subsequently positioned on the antenna substrate by means of an application device (61) and contacting of the antenna contact surfaces of the chip module with the contact surfaces of the antenna is performed,
**characterized in that**
for performing the separation, the row arrangement (21 to 26) of the chip modules (27) is guided out of a supply channel (62) until a rear longitudinal end (28) of the chip module protruding from the supply channel is brought into contact with a first fixed cutting edge (65) of the separating device (60), which defines the end of the supply channel, and a cutting arm (66) comprising a second cutting edge (67) is subsequently swiveled past the fixed cutting edge for separating the foremost chip module from the row arrangement and for transfer to the application device (61).

2. Method according to claim 1,
**characterized in that**
the sheet carrier (20, 97) features a plurality of row arrangements (21 to 26; 98 to 100) which extend in parallel to one another in the longitudinal direction of the sheet carrier and which are separated at a distance from the application location (102, 103, 104) in order to be supplied to the separating device (60) at the application location in the form of individual row arrangements.

3. Method according to claim 2,
**characterized in that**
the separation of the row arrangements (98 to 100) from the sheet carrier (97) is performed while the row arrangement is supplied to the separating device (60).

4. Method according to claim 2,
**characterized in that**
the separation of the row arrangements (98 to 100) from the sheet carrier (97) is performed independently of the supply of the row arrangement to the separating device (60).

5. Method according to claim 4,
**characterized in that**
the row arrangements (98 to 100) separated from the sheet carrier (97) are each rolled up and arranged on a storage device (58) in the form of a storage roll (105) and are subsequently supplied to the separating device starting from the storage device.

6. Method according to any of the preceding claims,
**characterized in that**
subsequent to the positioning and preceding the contacting in a contact region (94) surrounding a chip (96) and the antenna contact surfaces (34, 35), an adhesively bonded connection is established between the chip module (27) and the antenna substrate (49).

7. Method according to any of the preceding claims,
**characterized in that**
subsequent to the contacting in a contact region (94) surrounding a chip (96) and the antenna contact surfaces (34, 35), an adhesively bonded connection is established between the chip module (27) and the antenna substrate (49).

8. Method according to claim 1,
**characterized in that**
the foremost chip module (27) is retained on an abutment surface (74) of the cutting arm (66) while being separated from the row arrangement (21 to 26) and while being transferred to the application device (61).

9. Method according to claim 8,
**characterized in that**
the chip module (27) is retained against the abutment surface (74) with the aid of the application of underpressure.

10. Method according to claim 9,
**characterized in that**
for transferring the chip module (27) to the application device (61), the cutting arm (66) is swiveled against an abutment surface (75) of the application device (61) in such a manner that the application of underpressure at the cutting arm is maintained until abutment against the abutment surface of the application device is reached and underpressure is subsequently applied to the chip module via the abutment surface (75) of the application device.

11. Method according to one or more of the preceding claims,
**characterized in that**
for positioning with subsequent contacting, the application device (61) comprising the chip module (27) retained on the abutment surface (75) is moved against the antenna substrate (49) and is exposed to ultrasonic vibrations while abutting against the antenna substrate.

12. Method according to one or more of the preceding claims,
**characterized in that**
for producing the contact region (94), the chip module is exposed to ultrasonic vibrations in the contact region when the adhesively bonded connection between the chip module (27) and the antenna substrate (49) is established.

13. Method according to one or more of the preceding claims,
**characterized in that**
for supplying, separating and applying the chip modules (27), a plurality of antenna modules (37) disposed in a matrix arrangement (42) are assigned a number of row arrangements (21 to 26) of the chip modules (27) of the matrix arrangement, said number corresponding to the number of rows (43 to 48) of the matrix arrangement which are advanced into the feeding direction (50) in such a manner that the row arrangements are advanced into the same direction jointly with the assigned rows.

14. Method according to claim 13,
**characterized in that**
the supplying devices (59), separating devices (60) and application devices (61) assigned to each row (43 to 48) of the matrix arrangement (42) are accommodated in a stationary portal arrangement (51) and the antenna modules (37) disposed in the matrix arrangement are passed through underneath the portal arrangement in a clocked manner.

15. Device for application of a chip module (27) to an antenna module (37) comprising a supply device (59) for supplying a plurality of chip modules arranged in a row arrangement (21 to 26) on a sheet carrier (20), a separating device (60) for separating the chip modules from the row arrangement and transferring the separated chip module to an application device (61), wherein the application device serves for positioning the chip module on an antenna substrate (49) of the antenna module (37) and for contacting antenna contact surfaces (34, 35) of the chip module with the contact surfaces (40, 41) of the antenna (39),
**characterized in that**
the separating device (60) features a supply channel (62) comprising a cutting edge (65) formed at the frontal end in the feeding direction and a cutting arm (66) being swivelable with respect to the supply channel and comprising a second cutting edge (67) which can be moved past the first cutting edge.

16. Device according to claim 15,
**characterized in that**
the cutting arm (66) is furnished with an abutment surface (74) for accommodating the chip module (27) and being equipped with a retainer device for fixing the chip module to the abutment surface.

17. Device according to claim 16,
**characterized in that**
the retainer device is formed as an underpressure device which is arranged in the abutment surface.

18. Device according to any of claims 15 to 17,
**characterized in that**
the cutting arm (66), with the abutment surface (74) thereof, is swivelable against an abutment surface (75) of the application device (61) and the abutment surface of the application device is equipped with an underpressure device (76) for taking over the chip module from the abutment surface of the cutting arm.

19. Device according to any of claims 15 to 18,
**characterized in that**
the application device (61) features a feeding device for moving the chip module (27) arranged on the abutment surface (75) against the antenna substrate (49) and an ultrasonic device for exposing the chip module arranged on the abutment surface to ultrasonic vibrations.

20. Device according to any of claims 15 to 19,
**characterized in that**
the supply device (59), the separating device (60) and the application device (61) form an application module (52 to 57) that is arranged on a common carrier frame.

21. Device according to claim 20,
**characterized in that**
the application module (52 to 57) is equipped with a storage device (58) for arrangement of an endless sheet carrier (20) in the form of a roll.

22. Device according to claim 20 or 21,
**characterized in that**
the application modules (52 to 57) can be combined in any optional number for forming an application unit.

## Revendications

1. Procédé pour l'application d'un module de puce (27) sur un module d'antenne (37), dans lequel des surfaces de contact d'antenne (34, 35) formées sur un côté d'application (36) du module de puce sont contactées de manière électriquement conductrice avec des surfaces de contact (40, 41) d'une antenne (39) étant disposée sur un côté d'antenne d'un substrat d'antenne (49), dans lequel une pluralité de modules de puce est disposée dans un agencement en série (21 à 26; 98 à 100) sur un support de feuille (20, 97) et l'agencement en série est acheminé vers un dispositif de séparation (60) étant disposé à l'endroit d'application (102, 103, 104) au moyen d'un dispositif d'alimentation (59), le module de puce qui a été séparé de l'agencement en série est ensuite placé sur le substrat d'antenne au moyen d'un dispositif d'application (61) et les surfaces de contact d'antenne du module de puce sont contactées avec les surfaces de contact de l'antenne,
**caractérisé en ce que**
aux fins de la séparation, l'agencement en série (21 à 26) des modules de puce (27) est acheminé hors d'un canal d'alimentation (62) jusqu'à ce qu'une extrémité longitudinale arrière (28) du module de puce faisant saillie du canal d'alimentation vienne en contact avec un premier bord de découpage (65) fixe du dispositif de séparation (60), qui définit l'extrémité du canal d'alimentation, et un bras de découpage (66) comprenant un second bord de découpage (67) est ensuite pivoté au-delà du bord de découpage fixe pour séparer le module de puce le plus en avant de l'agencement en série et pour le transférer au dispositif d'application (61).

2. Procédé selon la revendication 1,
**caractérisé en ce que**
le support de feuille (20, 97) présente une pluralité d'agencements en série (21 à 26; 98 à 100) qui s'étendent en parallèle l'un par rapport à l'autre dans la direction longitudinale du support de feuille et qui sont séparés à une certaine distance de l'endroit d'application (102, 103, 104) afin d'être acheminés vers le dispositif de séparation (60) à l'endroit d'application sous la forme d'agencements en série individuels.

3. Procédé selon la revendication 2,
**caractérisé en ce que**
la séparation des agencements en série (98 à 100) du support de feuille (97) est effectuée alors que l'agencement en série est acheminé vers le dispositif de séparation (60).

4. Procédé selon la revendication 2,
**caractérisé en ce que**
la séparation des agencements en série (98 à 100) du support de feuille (97) est effectuée indépendamment de l'acheminement de l'agencement en série vers le dispositif de séparation (60).

5. Procédé selon la revendication 4,
**caractérisé en ce que**
les agencements en série (98 à 100) qui ont été séparés du support de feuille (97) sont chacun enroulés et agencés sous la forme d'un rouleau de stockage (105) sur un dispositif de stockage (58) et sont ensuite acheminés vers le dispositif de séparation à partir du dispositif de stockage.

6. Procédé selon l'une quelconque des revendications précédentes,
**caractérisé en ce que**
suivant le positionnement et précédant la mise en contact dans une zone de contact (94) environnant une puce (96) et les surfaces de contact d'antenne (34, 35), une connexion adhésive est produite entre le module de puce (27) et le substrat d'antenne (49).

7. Procédé selon l'une quelconque des revendications précédentes,
**caractérisé en ce que**
suivant la mise en contact dans une zone de contact (94) environnant une puce (96) et les surfaces de contact d'antenne (34, 35), une connexion adhésive est produite entre le module de puce (27) et le substrat d'antenne (49).

8. Procédé selon la revendication 1,
**caractérisé en ce que**
le module de puce (27) le plus en avant est retenu sur une surface de butée (74) du bras de découpage (66) tout en étant séparé de l'agencement en série (21 à 26) et tout en étant transféré au dispositif d'application (61).

9. Procédé selon la revendication 8,
**caractérisé en ce que**
le module de puce (27) est retenu contre la surface de butée (74) moyennant l'application d'une dépression.

10. Procédé selon la revendication 9,
**caractérisé en ce que**
le bras de découpage (66) est pivoté contre une surface de butée (75) du dispositif d'application (61) pour le transfert du module de puce (27) au dispositif d'application (61) de telle manière que l'application d'une dépression au bras de découpage est maintenue jusqu'à la venue en butée de celui-ci contre la surface de butée du dispositif d'application, et une dépression est ensuite appliquée au module de puce à l'aide de la surface de butée (75) du dispositif d'application.

11. Procédé selon l'une ou plusieurs des revendications précédentes,
**caractérisé en ce qu'**
aux fins du positionnement et de la mise en contact subséquente, le dispositif d'application (61) comprenant le module de puce (27) étant retenu sur la surface de butée (75) est déplacé contre le substrat d'antenne (49) et est soumis à des vibrations ultrasoniques en venant en butée contre le substrat d'antenne.

12. Procédé selon l'une ou plusieurs des revendications précédentes,
**caractérisé en ce qu'**
aux fins de la production de la zone de contact (94), le module de puce est soumis à des vibrations ultrasoniques dans la zone de contact alors que la connexion adhésive entre le module de puce (27) et le substrat d'antenne (49) est produite.

13. Procédé selon l'une ou plusieurs des revendications précédentes,
**caractérisé en ce qu'**
aux fins de l'acheminement, de la séparation et de l'application des modules de puce (27), à une pluralité de modules d'antenne (37) étant disposés dans un agencement matriciel (42) est attribué un nombre d'agencements en série (21 à 26) des modules de puce (27) de l'agencement matriciel, ledit nombre correspondant au nombre des rangées (43 à 48) de l'agencement matriciel qui sont avancées dans la direction de transfert (50) de telle manière que les agencements en série sont avancés dans la même direction conjointement avec les rangées attribuées.

14. Procédé selon la revendication 13,
**caractérisé en ce que**
les dispositifs d'alimentation (59), les dispositifs de séparation (60) et les dispositifs d'application (61) attribués à chaque rangée (43 à 48) de l'agencement matriciel (42) sont logés dans un agencement de portail (51) stationnaire, et les modules d'antenne (37) étant disposés dans un agencement matriciel sont passés par-dessous l'agencement de portail de manière cadencée.

15. Dispositif pour l'application d'un module de puce (27) sur un module d'antenne (37) comprenant un dispositif d'alimentation (59) pour l'acheminement d'une pluralité de modules de puce étant disposés dans un agencement en série (21 à 26) sur un support de feuille (20), un dispositif de séparation (60) pour la séparation des modules de puce de l'agencement en série et pour le transfert du module de puce qui a été séparé à un dispositif d'application (61), le dispositif d'application servant pour le positionnement du module de puce sur un substrat d'antenne (49) du module d'antenne (37) et pour la mise en contact des surfaces de contact d'antenne (34, 35) du module de puce avec les surfaces de contact (40, 41) de l'antenne (39),
**caractérisé en ce que**
le dispositif de séparation (60) présente un canal d'alimentation (62) comprenant un bord de découpage (65) formé à l'extrémité frontale dans la direction de transfert et un bras de découpage (66) pouvant être pivoté par rapport au canal d'alimentation et comprenant un second bord de découpage (67) pouvant être déplacé au-delà du premier bord de découpage.

16. Dispositif selon la revendication 15,
**caractérisé en ce que**
le bras de découpage (66) est muni d'une surface de butée (74) pour le logement du module de puce (27), ladite surface de butée étant munie d'un dispositif de retenue pour la fixation du module de puce à la surface de butée.

17. Dispositif selon la revendication 16,
**caractérisé en ce que**
le dispositif de retenue est conçu en tant que dispositif de dépression étant agencé dans la surface de butée.

18. Dispositif selon l'une quelconque des revendications 15 à 17,
**caractérisé en ce que**
le bras de découpage (66) avec sa surface de butée (74) peut être pivoté contre une surface de butée (75) du dispositif d'application (61) et la surface de butée du dispositif d'application est munie d'un dispositif de dépression (76) pour la prise en charge du module de puce de la surface de butée du bras de découpage.

19. Dispositif selon l'une quelconque des revendications 15 à 18,
**caractérisé en ce que**
le dispositif d'application (61) présente un dispositif d'avancement pour le déplacement du module de puce (27) étant disposé sur la surface de butée (75) contre le substrat d'antenne (49) et un dispositif à ultrasons pour la soumise du module de puce étant agencé sur la surface de butée à des vibrations ultrasoniques.

20. Dispositif selon l'une quelconque des revendications 15 à 19,
**caractérisé en ce que**
le dispositif de transfert (59), le dispositif de séparation (60) et le dispositif d'application (61) conjointement forment un module d'application (52 à 57) qui est agencé sur un cadre de soutien commun.

21. Dispositif selon la revendication 20,
**caractérisé en ce que**
le module d'application (52 à 57) est muni d'un dispositif de stockage (58) pour l'agencement d'un support de feuille (20) infini sous la forme d'un rouleau.

22. Dispositif selon la revendication 20 ou 21,
**caractérisé en ce que**
les modules d'application (52 à 57) peuvent être combinés d'une manière quelconque pour former une unité d'application.
